# EUROPÄISCHE PATENTSCHRIFT

(11) **EP 0 755 520 B1**
(45) Veröffentlichungstag und Bekanntmachung des Hinweises auf die Patenterteilung: **22.10.1997**
(21) Anmeldenummer: 95915773.6
(22) Anmeldetag: 11.04.1995
(51) Int. Cl.: G01R 31/12

(54) **VERWENDUNG EINER PRÜFFLÜSSIGKEIT ZUR KONTROLLE DER FUNKTIONSFÄHIGKEIT ELEKTRISCHER KRAFTWERKSKOMPONENTEN**
USE OF A TEST LIQUID FOR CHECKING THE EFFICIENCY OF ELECTRIC POWER STATION COMPONENTS
UTILISATION D'UN LIQUIDE DESTINE AU CONTROLE DU FONCTIONNEMENT DE COMPOSANTS ELECTRIQUES D'UNE CENTRALE ELECTRIQUE

(30) Priorität: 15.04.1994 DE 4413210
(43) Veröffentlichungstag der Anmeldung: 29.01.1997
(73) Patentinhaber: SIEMENS AKTIENGESELLSCHAFT, 80333 München (DE)
(72) Erfinder: KLECKA, Frantisek, D-63755 Alzenau (DE); LEDER, Christian, D-91301 Forchheim (DE); WULFF, Rainer, D-90408 Nürnberg (DE); WARNKEN, Lüder, D-91052 Erlangen (DE)
(86) Internationale Anmeldenummer: DE9500497
(87) Internationale Veröffentlichungsnummer: WO9528647

(56) Entgegenhaltungen:
- FR-A- 2 225 819
- PROCEED. IEE, Bd. 125, Nr. 12, Dezember 1978 Seiten 1363-1366, CAKEBRAED ET AL. 'automatic insulator-washing system to prevent flashover due to pollution'

## Beschreibung

Die Erfindung betrifft die Verwendung einer Prüfflüssigkeit zur Nachbildung der Einflüsse eines Kühlmittelkondensats auf eine elektrische Kraftwerkskomponente im Fall eines Störfalls mit Austritt von Kühlmittelkondensat. Aus dem Dokument FR-A-2 225 819 ist es bekannt, eine Prüfflüssigkeit zur Benetzung eines isolierten Kabels zu verwenden, um dessen Isolation zu prüfen.

Im Falle eines Kühlmittelverluststörfalls (KMV-Störfall) kommt es im allgemeinen zu einer starken Dampfproduktion. Das daraufhin anfallende Kondensat benetzt zahlreiche Komponenten - auch der Energieerzeugung und -verteilung und der Leittechnik. Es entsteht ein feuchter Film, der durch Verunreinigungen der Komponentenoberfläche leitend wird. Wenn eine dieser Komponenten durch das sie benetzende Kondensat in ihrer Funktionsfähigkeit eingeschränkt bzw. zerstört wird, z. B. weil ihre Kabel, Verteiler und Durchführungen schlecht isoliert sind, so kann dies dazu führen, daß die zur Beherrschung des Störfalls notwendigen Maßnahmen erschwert werden. Ferner müssen dann neben dem Kühlmittel system auch noch die durch das Kondensat beschädigten Komponenten repariert werden.

Um solche Schäden zu vermeiden, werden alle Komponenten eines Kraftwerks, die im Falle eines KMV-Störfalls von Kondensat benetzt werden könnten, so gebaut, daß sie durch eine Benetzung bei Störfallbedingungen in ihrer Funktionsfähigkeit nicht eingeschränkt werden, z. B. verkapselt, vergossen oder mit langen Kriechstrecken ausgestattet (sogenannte KMV-Festigkeit).

Da Isolationswerkstoffe in der Regel altern und sich die KMV-Festigkeit während der Lebensdauer einer Komponente durch Einflüsse von außen und auch den Betrieb der Komponente selbst verringern kann, sollte die KMV-Festigkeit der betreffenden Komponenten regelmäßig mit geeigneten Verfahren überprüft werden. Ein solches Verfahren ist Inhalt der gleichzeitig eingereichten Patentanmeldung "Verfahren und Prüfflüssigkeit zur Kontrolle der Funktionsfähigkeit elektrischer Kraftwerkskomponenten" (DE-A-4 413 110).

Insbesondere gestattet das Verfahren eine derartige Prüfung, ohne daß die Komponente dabei ausgebaut werden muß. So können z. B. Anschlüsse oder Verteiler im betriebsfertigen Zustand ohne Zerstörung oder Demontage getestet werden; die Prüfung ist sogar während des laufenden Betriebes möglich.

Das Prüfverfahren gemäß dieser Patentanmeldung "Verfahren und Prüfflüssigkeit zur Kontrolle der Funktionsfähigkeit elektrischer Kraftwerkskomponenten" sieht vor, die Benetzung durch Kondensat im Falle des KMV-Störfalls durch das Auftragen einer gut benetzenden Prüfflüssigkeit definierter Leitfähigkeit zu simulieren, um dann als Wert für die Funktionsfähigkeit der Komponente den Isolationswiderstand zu messen. Danach wird die Oberfläche wieder getrocknet. Dabei kann die Oberfläche vorzugsweise vor dem Trocknen mit einem rückstandsfrei entfernbaren Spülmedium gespült werden.

Tritt insbesondere z. B. bei einem leichtwassergekühlten Kernreaktor ein Riß im Kühlmittelsystem auf, so tritt das Wasser wegen des hohen Drucks mit der erhöhten Betriebstemperatur in andere Teile des Kraftwerks aus, in denen sich elektrische Komponenten befinden. Dieses Wasser kondensiert an den verschiedenen Bauteilen, von denen es zwar weitgehend abtropft (vor allem, wenn deren Oberfläche sehr sauber ist), an denen es sich aber, wenn sich nach längeren Betriebszeiten. Staub abgelegt hat, mit diesem Schmutz mischt. Das führt dazu, daß sich z. B. an den Magnetantrieben für die Steuerstäbe, den Steuer- und Regeleinrichtungen und Signalanlagen ein feuchter Schmutzfilm von etwa 160 °C bildet, der zu Kurzschlüssen in der Stromversorgung, zu Fehlsignalen oder Signalausfällen und anderen Fehlern führen kann, die die Funktion dieser Einrichtungen stören. Dabei wird die Störanfälligkeit durch den Druck des Kühlmitteldampfes noch gefördert.

Das Verfahren erkennt die Gefahr derartiger Funktionsstörungen rechtzeitig, um geeignete Gegenmaßnahmen (z. B. Auswechseln der gefährdeten Komponenten) ergreifen zu können.

Der Erfindung liegt die Aufgabe zugrunde, für derartige Prüfungen eine geeignete Prüfflüssigkeit zur Verfügung zu stellen.

Die Erfindung sieht die Verwendung einer Prüfflüssigkeit vor, die bezüglich der Oberflächenspannung und der Leitfähigkeit gestattet, die Einflüsse des Kühlmittelkondensats nachzubilden. Die Leitfähigkeit und die Oberflächenspannung der Prüfflüssigkeit bei der Temperatur der Messungen sind also vorteilhaft etwa gleich der Leitfähigkeit und der Oberflächenspannung des anfallenden Kondensats im Störfall.

Für den KMV-Störfall wird eine vollständige Benetzung der Bauteile durch anfallendes Kondensat vermutet. Es herrschen Sattdampfbedingungen bei 160 °C. Von Interesse für die angestrebte Ersatzprüfung ist das "Netzvermögen" des Kondensats unter diesen Bedingungen, d. h., der Grad der Fähigkeit, die Oberfläche eines Isolators zu benetzen und damit einen geschlossenen Film zu bilden (Definition gemäß DIN 53900).

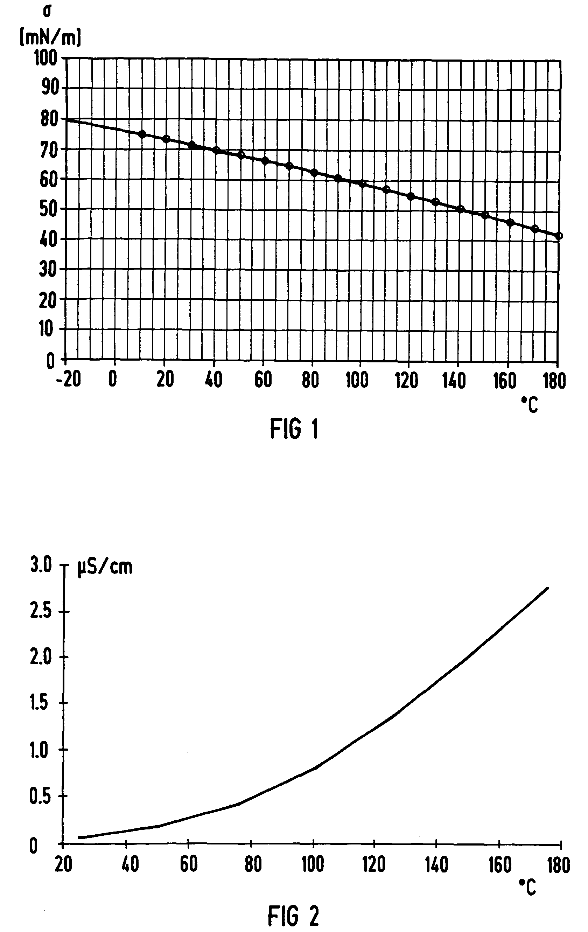

Diese Benetzungstendenz einer Flüssigkeit ist um so größer, je kleiner die Oberflächenspannung "Sigma" ist. Figur 1 zeigt die Oberflächenspannung von Deionat gegen Luft in Abhängigkeit von der Temperatur. Es ist ersichtlich, daß die Oberflächenspannung mit steigender Temperatur deutlich abnimmt, wodurch im KMV-Störfall bei 160 ° (Oberflächenspannung des Deionats 47 mN/m) eine bessere Benetzung der Oberfläche durch das anfallende Kondensat vorliegt als bei Raumtemperatur.

Eine weitere Einflußgröße ist die elektrische Leitfähigkeit des Kondensats. In Figur 2 ist die Leitfähigkeit von reinem Deionat als Funktion der Temperatur dargestellt (bei 160 °C: ca. 2µS/cm). In der Regel ist das Kühlwasser eines Kernkraftwerkes hochrein, jedoch ist manchmal aus anderen Gründen eine gewisse Menge Borlösung zugefügt. Ausgehend von der ungünstigsten Annahme, daß der KMV-Störfall bei einer maximalen Borkonzentration von 2200 ppm im Kühlmittel abläuft, wird über den Dampfpfad des Kühlmittels ein geringer Anteil Bor, der im Kondensat eine Borkonzentration (in Form von Borsäure) von 20 ppm verursacht, mitgerissen. Dieser Anteil bewirkt eine geringe Leitfähigkeit von 0,3 µS/cm bei 25 °C und kann vernachlässigt werden, zumal sich der Beitrag der Leitfähigkeit nur wenig auf die Isolationswiderstandsmessung auswirkt.

Die erfindungsgemäß verwendete Prüfflüssigkeit weist die im Anspruch 1 angegebenen Merkmale auf. Es eignet sich also eine Prüfflüssigkeit, die möglichst verträglich mit den im Kraftwerk verwendeten Werkstoffen ist, und die eine Leitfähigkeit bei Raumtemperatur zwischen 1 und 6 µS/cm und die eine Oberflächenspannung bei Raumtemperatur bis 50 mN/m aufweist, wobei die Flüssigkeit leicht von der Oberfläche entfernbar ist. Insbesondere kann mit der Erfindung eine Prüfflüssigkeit hergestellt werden, deren Oberflächenspannung und Leitfähigkeit bei Normaldruck und im Bereich normaler Raumtemperaturen in der selben Größenordnung liegen wie bei Deionat bei 160 °C. Außerdem treten durch die Anwendung der Flüssigkeit keine Rückwirkungen auf die Prüflingseigenschaften und -lebensdauer auf. Ferner ist die Prüfflüssigkeit problemlos handhabbar sowie gesundheitsvertraglich in der Anwendung sein.

Eine vorteilhafte Prüfflüssigkeit ist durch Verdünnung eines nicht-ionischen Benetzungsmittels mit entionisiertem Wasser eingestellt. Dies entspricht der Tatsache, daß das Kühlsystem der Kernreaktoren hochreines (entionisiertes) Wasser enthält, dem lediglich eine geringe Menge Bor zugesetzt ist. Ferner hat es den Vorteil, daß die Prüfflüssigkeit an allen Kraftwerksanlagen durch Verdünnen eines Konzentrats, das dort auf Vorrat bereit gehalten werden kann, leicht herstellbar ist.

Vorteilhaft ist die Oberflächenspannung der Prüfflüssigkeit etwa im Bereich zwischen 15 °C bis 35 °C, also im Bereich normaler Zimmertemperaturen, temperaturunabhängig, so daß zur Prüfung keine besondere Temperierung des Kraftwerks erforderlich ist.

Da die Oberflächenspannung des Kondensats circa 47 mN/m und die Leitfähigkeit circa 2,5 µS/cm beträgt, hat eine vorteilhafte Prüfflüssigkeit eine Oberflächenspannung von etwa 25 bis 50 mN/m und eine Leitfähigkeit von etwa 1 bis 6 µS/cm, wodurch die Prüfflüssigkeit die Einflüsse des Kondensats vergleichbar nachbildet. Die geringe Oberflächenspannung bewirkt zudem ein vollständiges, reproduzierbares Benetzen der Komponentenoberflachen.

Vorteilhaft werden Polyglykoläther als Netzmittel für das entionisierte Wasser verwendet. Als nicht-ionische Tenside beeinflussen sie die Leitfähigkeit bei einem Anteil von 0,01 bis 0,5 Gew.-% nur geringfügig und haben somit die erwähnten erwünschten Vorteile. Als insbesonders geeignet erweist sich ein Gehalt von 0,1 ± 0,05 Gew.-% eines Polyglykoläthers der allgemeinen Formel R-CH₂-O(CH₂CH₂O)ₙH, wobei R ein Rest eines Fettalkohols mit der mittleren Kettenlänge von 13 C-Atomen ist und n zwischen 5 und etwa 15 liegt. Die Netzwirkung steigt mit zunehmenden Äthylenoxid an, erreicht bei n = 8 ein Optimum und fällt mit weiter steigendem n wieder leicht ab. Als insbesonders vorteilhaftes Netzmittel wird also R-CH₂-O(CH₂CH₂O)₈H verwendet, das vor allem im niedrigen Temperaturbereich ein besonders gut ausgeprägtes Netzvermögen besitzt und zudem sehr gut wasserlöslich ist.

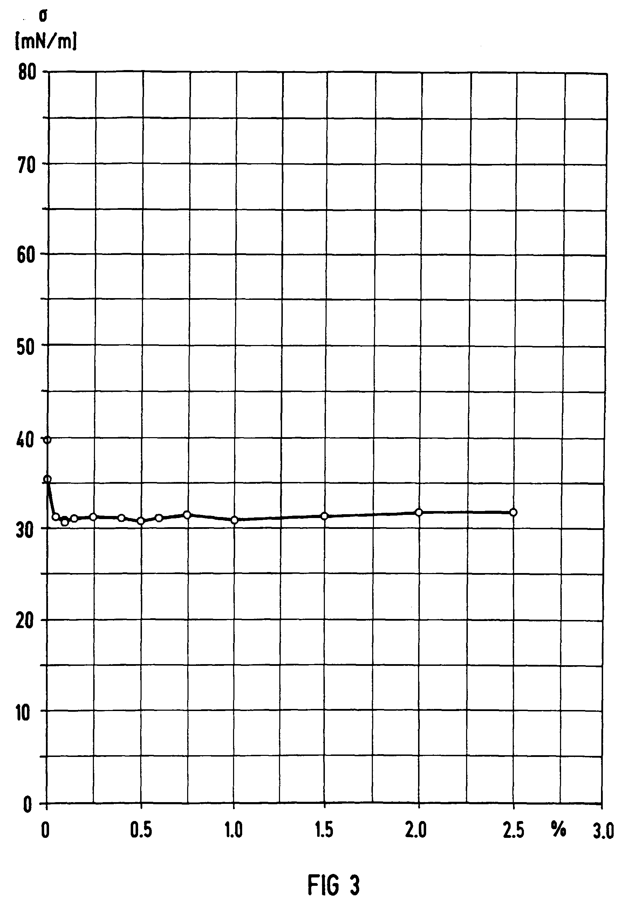

Aus Figur 3 ist die Oberflächenspannung von Deionat mit verschiedenen Zumischung von diesem Netzmittel zu entnehmen. Die zudem ein vollständiges, reproduzierbares Benetzen der Komponentenoberflächen.

Vorteilhaft werden Polyglykolether als Netzmittel für das weitgehend entionisierte Wasser verwendet. Als nicht-ionische Tenside beeinflussen sie die Leitfähigkeit bei einem Anteil von 0,01 bis 0,5 Gew.-% nur geringfügig und haben somit die erwähnten erwünschten Vorteile. Als insbesonders geeignet erweist sich ein Gehalt von 0,1 ± 0,05 Gew.-% eines Polyglykolethers der allgemeinen Formel R-CH₂-O(CH₂CH₂O)ₙH, wobei R ein Rest eines Fettalkohols mit der mittleren Kettenlänge von 13 C-Atomen ist und n zwischen 5 und etwa 15 liegt. Die Netzwirkung steigt mit zunehmenden Ethylenoxid an, erreicht bei n = 8 ein Optimum und fällt mit weiter steigendem n wieder leicht ab. Als insbesonders vorteilhaftes Netzmittel wird also R-CH₂-O(CH₂CH₂O)₈H verwendet, das vor allem im niedrigen Temperaturbereich ein besonders gut ausgeprägtes Netzvermögen besitzt und zudem sehr gut wasserlöslich ist.

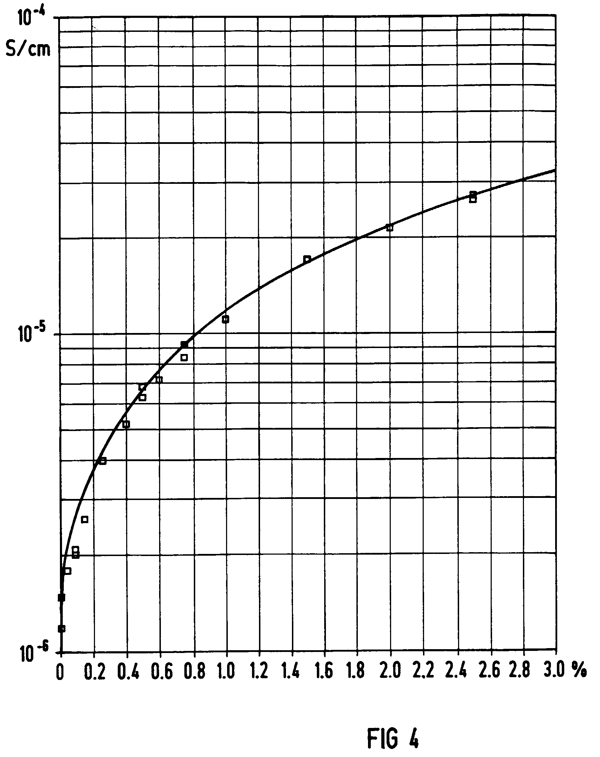

Aus Figur 3 ist die Oberflächenspannung von Deionat mit verschiedenen Zumischung von diesem Netzmittel zu entnehmen. Die beiden Meßwerte, die für einen Gewichtsanteil von 0 % des Netzmittels anegeben sind, entsprechen einer Verdünnung von einem bzw. zwei Tropfen in 1000 g Deionat. Wie zu ersehen ist, stellt sich bereits ab 0,05 Gew.-% Netzmittelzumischung ein Oberflächenspannungswert von circa 31 mN/m ein, der auch bei höherer Zumischung nicht weiter fällt. Die Oberflächenspannung des Kondensats (Deionats) im KMV-Störfall bei 160 ° beträgt etwa 47 mN/m (vergleiche Figur 1). Das Netzvermögen des Prüfmediums liegt damit in der Größenordnung des sich im KMV-Störfall niederschlagenden Kondensats. Gleiches trifft für den Parameter elektrische Leitfähigkeit zu. Wie Figur 4 zeigt, ergibt eine Zumischung von 0,1 Gew.-% des Netzmittels eine Leitfähigkeit von circa 2 µS/cm. Somit liegt auch hier die gleiche Größenordnung vor wie für Deionat bei 160 °C (siehe Figur 2).

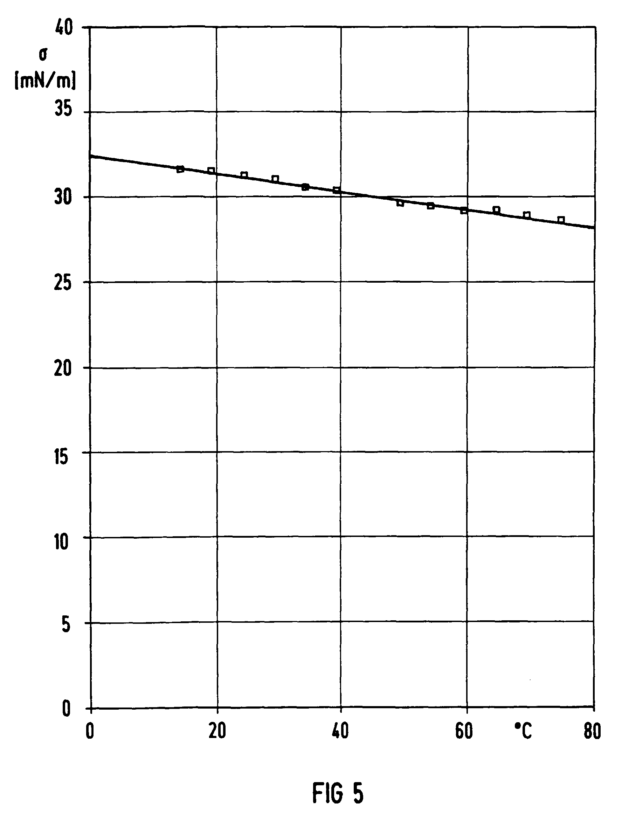

Wie Figur 5 zeigt, verändert sich die Oberflächenspannung dieses Prüfmediums zwischen 15 ° und 35 ° nur geringfügig. Die ausgezogene Kurve zeigt eine Exponentialfunktion, nach der der jeweilige Wert auch für höhere Temperaturen extrapolient werden kann.

Figur 3 zeigt auch, daß für die Netzmittelkonzentration bei 0,1 Gew.-% durchaus weite Toleranzgrenzen möglich sind, ohne die Reproduzierbarkeit der Oberflächenspannung zu stören. Daher kann man als Netzmittelkonzentration 0,1 ± 0,05 Gew.-% zulassen.

Durch Verdünnung dieses Netzmittels ist also an jeder Kraftwerksanlage leicht eine Standardprüfflüssigkeit herstellbar, die den erwähnten Anforderungen voll entspricht. Eventuelle Rückstände des Netzmittels bzw. der Prüfflüssigkeit können durch anschließendes Spülen mit entionisiertem Wasser leicht entfernt werden.

## Patentansprüche

1. Verwendung einer Prüfflüssigkeit zur Nachbildung der Einflüsse eines Kühlmittelkondensats auf eine elektrische Kraftwerkskomponente im Falle eines Störfalls mit unkontrolliertem Austritt des Kühlmittelkondensats, bei dem ein Film auf der Oberfläche der Kraftwerkskomponente gebildet wird, wobei die Prüfflüssigkeit
a) bei Raumtemperatur eine Leitfähigkeit zwischen 1 und 6 µS/cm aufweist,
b) bei Raumtemperatur eine Oberflächenspannung bis 50 mN/m aufweist, und
c) gegenüber dem Werkstoff der Kraftwerkskomponente praktisch inert und von der Oberfläche leicht entfernbar ist.

2. Verwendung der Prüfflüssigkeit nach Anspruch 1,
**dadurch gekennzeichnet**, daß die Oberflächenspannung durch Verdünnung eines nicht ionischen Benetzungsmittels mit entionisiertem Wasser eingestellt ist.

3. Verwendung der Prüfflüssigkeit nach Anspruch 1 oder 2,
**gekennzeichnet durch** eine zwischen 15 und 35 C° konstante Oberflächenspannung.

4. Verwendung der Prüfflüssigkeit nach einem der Ansprüche 1 bis 3,
**gekennzeichnet durch** einen Gehalt an Polyglykoläther zwischen 0,01 bis 0,5 Gew.-%, gelöst in entionisiertem Wasser.

5. Verwendung der Prüfflüssigkeit nach Anspruch 4,
**gekennzeichnet durch** einen Gehalt von 0,1 ± 0,05 Gew.-% eines Polyglykoläthers der allgemeinen Formel R-CH₂-O(CH₂CH₂O)ₙH , wobei R Rest eines Fettalkohols mit der mittleren Kettenlänge von 13 C-Atomen ist und n zwischen 5 und etwa 15 liegt.

6. Verwendung der Prüfflüssigkeit nach Anspruch 5, mit einem mittleren Wert n = 8.

7. Verwendung der Prüfflüssigkeit nach einem der Ansprüche 1 bis 6,
**gekennzeichnet durch** eine Viskosität des unverdünnten Netzmittels zwischen 60 und 100 mPas bei 20 °C.

## Claims

1. Use of a test liquid for simulating the effects of a coolant condensate on an electrical power station component in the event of an incident involving an uncontrolled outlet of the coolant condensate, in which a film is formed on the surface of the power station component, with the test liquid
a) having a conductivity between 1 and 6 µS/cm at room temperature,
b) having a surface tension up to 50 mN/m at room temperature, and
c) being practically inert with respect to the material of the power station component and easily removable from the surface.

2. Use of the test liquid according to claim 1, characterised in that the surface tension is adjusted by diluting a non-ionic wetting agent with deionised water.

3. Use of the test liquid according to claim 1 or 2, characterised by a surface tension which is constant between 15°C and 35°C.

4. Use of the test liquid according to one of the claims 1 to 3, characterised by a content of polyglycol ether of between 0.01 to 0.5 % by weight, dissolved in deionised water.

5. Use of the test liquid according to claim 4, characterised by a content of 0.1 ± 0.05 % by weight of a polyglycol ether of the general formula R-CH₂-O(CH₂CH₂O)ₙH, where R is a radical of a fatty alcohol with the average chain length of 13 C atoms and n is between 5 and approximately 15.

6. Use of the test liquid according to claim 5, with an average value n = 8.

7. Use of the test liquid according to one of the claims 1 to 6, characterised by a viscosity of the undiluted wetting agent of between 60 and 100 mPas at 20°C.

## Revendications

1. Utilisation d'un liquide de test pour simuler les influences d'une produit de condensation de fluide de refroidissement sur un composant électrique d'une centrale électrique dans le cas d'un incident comportant une sortie incontrôlée du produit de condensation de fluide de refroidissement, lors de laquelle on forme une pellicule à la surface du composant de la centrale électrique, le liquide de test
a) ayant à température ambiante une conductivité comprise entre 1 et 6 µS/cm,
b) ayant à température ambiante une tension superficielle pouvant aller jusqu'à 50 mN/m, et
c) étant pratiquement inerte par rapport au matériau du composant de la centrale électrique et pouvant être facilement éliminé de la surface.

2. Utilisation du liquide test suivant la revendication 1, caractérisée en ce que l'on règle la tension superficielle par dilution d'un agent mouillant non ionique par le l'eau désionisée.

3. Utilisation du liquide test suivant la revendication 1 ou 2, caractérisée par une tension superficielle constante entre 15 et 350° C.

4. Utilisation du liquide test suivant l'une des revendications 1 à 3, caractérisée par une teneur en polyétherglycol comprise entre 0,01 et 0,5 % en poids, dissoute dans de l'eau désionisée.

5. Utilisation du liquide test suivant la revendication 4, caractérisée par une teneur de 0,1 + ou - 0,05 % en poids d'un polyétherglycol de formule générale R-CH₂-O(CH₂CH₂O)ₙH, R étant un résidu d'un alcool gras ayant la longueur de chaîne moyenne de 13 atomes de carbone et n étant compris entre 5 et environ 15.

6. Utilisation du liquide test suivant la revendication 4, caractérisée par une valeur moyenne de n = 8.

7. Utilisation du liquide test suivant l'une des revendications 1 à 6, caractérisée par une viscosité de l'agent mouillant non dilué comprise entre 60 et 100 mPas à 20° C.
